# EUROPEAN PATENT SPECIFICATION

(11) **EP 4 210 184 B1**
(45) Date of publication and mention of the grant of the patent: **24.07.2024**
(21) Application number: 22305015.4
(22) Date of filing: 10.01.2022
(51) Int. Cl.: H01S 5/026, H01S 5/0234, H01S 5/042, H01S 5/12, H01S 5/22, H01S 5/227, H01S 5/00, H01S 5/028, H01S 5/125, H01S 5/02

(54) **ELECTRO-ABSORPTION MODULATED LASER DEVICE FOR FLIP-CHIP INTEGRATION**
ELEKTROABSORPTIONSMODULIERTE LASERVORRICHTUNG ZUR FLIP-CHIP-INTEGRATION
DISPOSITIF LASER MODULÉ PAR ÉLECTRO-ABSORPTION POUR L'INTÉGRATION D'UNE PUCE RETOURNÉE

(43) Date of publication of application: 12.07.2023
(73) Proprietor: Nokia Solutions and Networks Oy, 02610 Espoo (FI)
(72) Inventor: PARET, Jean François, 91290 Arpajon (FR); GARREAU, Alexandre, 92160 Antony (FR)
(74) Representative: Novagraaf Technologies

(56) References cited:
- EP-A1- 3 416 252
- JP-A- H10 256 669
- US-A1- 2004 238 828
- US-A1- 2018 067 341
- US-A1- 2021 066 537

## Description

### TECHNICAL FIELD

Various example embodiments relate to optoelectronic devices such as Electro-absorption Modulated Lasers (usually known by the acronym EML). In particular, embodiments according to the invention relate to the realization of such optoelectronic devices which are based on an one-step process of a Semi-insulated Buried Heterostructure (usually known by the acronym SiBH).

### BACKGROUND

As known by those skilled in the art, an EML is a laser diode integrated with an electro-absorption modulator (usually known by the acronym EAM) in a single chip. It can be applied to high frequency telecommunications (up to 100 Gbit/s) and long-distance transmission (10 km to 100 km) applications, because of its low chromatic dispersion. The laser diode section operates under a continuous wave condition (CW), and on/off voltage input signals are applied to the EAM section to generate optical output signals. The properties of the laser are not altered by the modulation process. The frequency response up to 100 GHz of an EML depends on a capacitance in the EAM section. The extinction in an EML is generated by the voltage modulated absorption of the EAM section.

Semi-insulated Buried Heterostructure (usually known by the acronym SiBH) is a commonly used technology for optoelectronic devices, for fast modulation components such as electro-absorbtion modulated laser (EML), semiconductor optical amplifiers (SOA), or more generally for photonic integrated circuits. In particular, the published European patent application EP 3416252A1 teaches a simplified one-step method for making a SIBH structure allowing electrical isolation between electrodes without the need for ion implantation.

However, the technology taught by EP 3416252A1 presents some drawbacks. Notably, The optoelectronic device with SiBH obtained by this technology is not flat, especially around the waveguide, because of the different growths of the [100] [110] or [111] crystalline plans. Moreover, the metal contacts are not at the same level. It imposes to generate pillars for the via contact on the device or on the flip chip package.

The no planarity of the device produces mechanical weakness. To avoid the last point, the general solution is to encapsulate the device in a resin R, but it generates a thermal resistivity. A bad heat evacuation strongly penalizes the performances of the chip.

An EML device including a Distributed Feedback Grating is disclosed in JP H10 256669 A (MITSUBISHI ) 25 September 1998.

Thus, in light of the foregoing, there is a need of a device composed of a laser working in a continuous wave condition and an EAM modulated in order to reach high frequencies without a limitation of optical power, wherein the manufacture of such a device is based on a one-step process of making a semi-insulating buried heterostructure (SIBH) where the p and n contacts are at the same level on the same wafer face and can be easily soldered to the package of the flip-chip package.

### SUMMARY

Example embodiments of the invention aim to remedy all or some of the disadvantages of the above identified prior art.

The embodiments and features, if any, described in this specification that do not fall under the scope of the independent claims are to be interpreted as examples useful for understanding various embodiments of the invention.

A general embodiment of the invention as claimed relates to an electro-absorption modulated laser (hereinafter referred to as the acronym EML) device comprising:
- a substrate made of III-V semiconductor material presenting a base and side walls and having a longitudinal axis XX, said substrate being etched to form a groove (11) of U-shaped cross-section,
- a layer of n-doped III-V semi-conductor disposed on the base inside said groove;
- a central stripe portion comprising a buried waveguide on which is grown a layer of p-doped III-V semi-conductor and a p-doped III-V semi-conductor contact layer (such as p-GaInAs) at least up to the level of the top of the side walls.
- two channels etched into the n-doped III-V semiconductor layer along the longitudinal axis XX and being located along each side wall on both sides of the central stripe portion, said channels being each filled by a regrown semi-insulating stack up to the level of the top of the the p-doped III-V semi-conductor contact layer;
- within a zone of the central stripe portion alongside the longitudinal axis XX constituting the first zone (I), a Distributed Feedback Grating (usually known a DFB grating) etched inside the layer of p-doped III-V semi-conductor, the remaining zone constituting the second zone.
- metal stripes (disposed on the top of the side walls and on the top of said the stripe portion;
- a first electrical separation (9) between the first I and second zones II consisting in a thin ribbon of implanted H+ located between the side walls and perpendicular to longitudinal axis XX.

The device of the general embodiment presents the following advantages:
- suppression of the mechanical weakness,
- minimizing the wire bonding thus permitting to limit the Joule effect due to the current intensity and also parasitic capacitance or inductance limiting the optical high speed data transmission,
- easy evacuation of the heat produced by the photon generation in the laser and the photon modulation in the EAM because of the no presence of resin generating a thermal resistivity.

According to a first example of the general embodiment (hereinafter referred to as first embodiment), the electro-absorption modulated laser may further comprise a dielectric mirror Rₘₐₓ positioned at the end of the first zone opposite to first electrical separation.

According to a second example of the general embodiment hereinafter referred to as second embodiment, the electro-absorption modulated laser may further comprise:
- a distributed Bragg Reflector (usually abbreviated by DBR) etched inside the layer of p-doped III-V semi-conductor within a first sub-zone located along said longitudinal axis XX in the first zone and outside the part of the first zone containing the Distributed Feedback Grating which constitutes the second sub-zone; and
- a second electrical separation between the first (I') and second sub-zoned consisting in another thin ribbon of implanted H+ located between the side walls and perpendicular to longitudinal axis XX.

Embodiments of the invention as claimed further provide a method of fabricating an electro-absorption modulated laser device (usually known by the acronym EML) comprising:
A. providing a substrate made of III-V semiconductor material with a longitudinal axis XX,
B. etching said substrate to form a groove of U-shaped cross-section and thus to define a base and side walls;
C. performing an epitaxial growth of a stack of layers comprising a layer of n-doped III-V semi-conductor on the base, an active material stack (such as Multi quantum Wells based on AlGaInP or GaInAsP) on said layer of n-doped III-V semi-conductor, and p-doped III-V semi-conductors (such as InP and AlGaInP or GaInAsP) constituting grating layers (5) ;
D. within a zone of electro-absorption modulated laser device alongside said longitudinal axis XX constituting the first zone, etching a Distributed Feedback Grating inside the grating layers, the remaining zone constituting the second zone,
E. performing an epitaxial growth of a layer of p-doped III-V semi-conductor (such as InP) to bury the Distributed Feedback Grating and a p-doped III-V semi-conductor contact layer (such as p-GaInAs);
F. depositing a dielectric mask on the layer of p-doped III-V semi-conductor;
G. etching, along the longitudinal axis XX, two channels at least below the level of the active material stack, each channel being located along each side wall of the substrate, so as to define a central stripe portion comprising the etched material stack constituting the optical waveguide and the etched layer of p-doped III-V semi-conductor;
H. performing an epitaxial regrowth of a semi-insulating stack up to the level of the top of the p-doped III-V semiconductor contact layer;
I. removing the remaining dielectric mask;
J. depositing, along said longitudinal axis XX, three metal stripes on the top of the side walls (13) and on the top of said central stripe portion;
K. forming a first electrical separation between the first and second zones by implanting H+ ions within a thin ribbon of implanted H+ located between the side walls and perpendicular to longitudinal axis

The active material stack (such as Multi Quantum Wells based on AlGaInP or GaInAsP) can be of different natures in the first and second zones by performing Selective Area Growth epitaxy or Butt-joint Technology.

Advantageously, the method of fabricating may further comprise between steps I and J, a step I' of chemical and/or mechanical surface stripping of the regrown semi-insulating stack, to flatten it to the level of the top of the side walls.

According to a first example, the method may further comprise the following step to obtain an electro-absorption modulated laser device according to the first example of the general embodiment (or first embodiment): step K of forming the first electrical separation is followed by a step L of positioning a dielectric mirror Rₘₐₓ at the end of the first zone opposite to first electrical separation.

According to a second example, the method may further comprise the following steps to obtain an electro-absorption modulated laser device according to the second example of the general embodiment (or second embodiment):
- step D may further comprise , etching of a Distributed Bragg Reflector inside the grating layers within a first sub-zone located along said longitudinal axis XX in the first zone and outside the part of the first zone containing the Distributed Feedback Grating which constitutes the second sub-zone, the etching of the Distributed Bragg Reflector and the etching of the Distributed Feedback Grating being realized simultaneously, and the burying of the Distributed Bragg Reflector and that of the Distributed Feedback Grating being realized simultaneously;
- wherein during step E), the Distributed Bragg Reflector and the Distributed Feedback Grating are buried simultaneously by the layer of p-doped III-V semiconductor; and
- wherein step K is followed by a step M of forming of a second electrical separation between the first and second sub-zone by implanting H+ ions within another ribbon of implanted H+ located between the side walls and perpendicular to longitudinal axis XX.

### BRIEF DESCRIPTION OF THE DRAWINGS

Some example embodiments are now described, by way of example only, and with reference to the accompanying drawings in which:
- FIG. 1 schematically represents two sectional views of Semi-Insulating Buried Heterostructures (SIBH) realized by a state-of-the-art one-step process of manufacture;
- FIG. 2 schematically represents these two sectional views of Semi-Insulating Buried Heterostructures (SIBH) realized by a state of the art a one-step process of manufacture in which pillars are generated for obtaining structures with metal contacts at the same level;
- FIGs. 3a1 to 3c schematically represent two embodiments of an EML device D according to the present invention;
- FIG. 4 schematically represents the electrical scheme of the EML device;
- FIGs. 5 to 10 schematically represent the different steps of the process flow for fabricating an EML device according to the embodiments represented in figures 3a-c:
   ∘ FIG. 5a to 5c schematically represent steps A and B;
   ∘ FIG. 6a to 6c schematically represent steps C to E;
   ∘ FIG. 7a to 7c schematically represent steps F and G;
   ∘ FIG. 8a to 8c schematically represent step H;
   ∘ FIG. 9a to 9c schematically represent step I;
   ∘ FIG. 10a to 10c schematically represent step I'
   ∘ steps K, L, and L' or M are schematically shown in figures 3a1, 3a2 to 3c (see above).

The same reference number represents the same element or the same type of element on all drawings, unless stated otherwise.

### DETAILLED DESCRIPTION

The figures and the following description illustrate specific exemplary embodiments of the invention. It will thus be appreciated that those skilled in the art will be able to devise various arrangements that, although not explicitly described or shown herein, embody the principles of the invention and are included within the scope of the invention. Furthermore, any examples described herein are intended to aid in understanding the principles of the invention and are to be construed as being without limitation to such specifically recited examples and conditions. As a result, the invention is not limited to the specific embodiments or examples described below, but by the claims.

In the following description, well-known functions or constructions by the man skilled in the art are not described in detail since they might obscure the invention in unnecessary detail.

In the following description of the figures, schematic representations are non-limiting and serve only for the understanding of the invention.

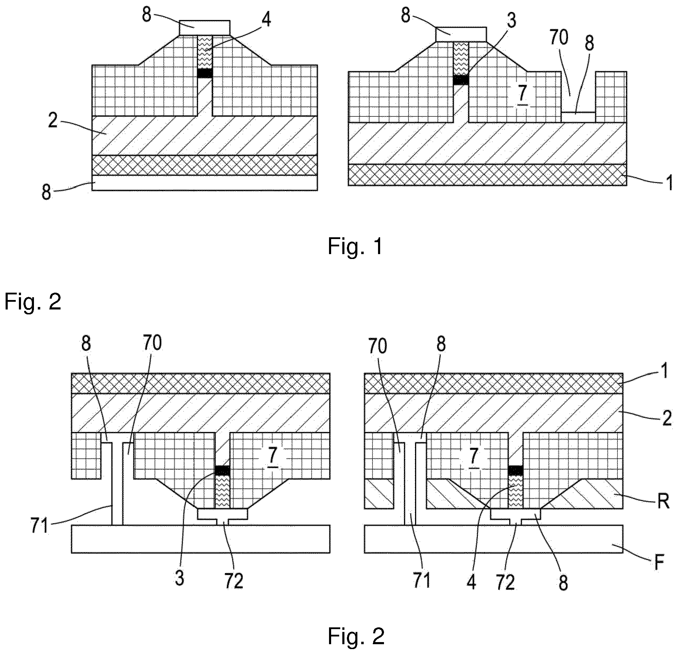

FIG. 1 schematically represents two sectional views of Semi-Insulating Buried Heterostructures (SIBH) realized by a state-of-the-art one-step process of manufacture. In particular, FIG. 1 shows that a p metal contact 8 is deposited on a p-doped III-V semiconductor 4 and/or on the front side of the n doped III-V semiconductor 2 (see FIG. 1, right scheme). The last solution implies the etching of a via 70 in the SIBH layer 7 until reaching a doped III-V layer 2 connected to the III-V substrate 1. The optoelectronic device with SiBH obtained by this technology is not flat, especially around the waveguide 3, because of the different growths of the [100] [110] or [111] crystalline layers. Moreover, the metal contacts 8 are not at the same level. It imposes to generate pillars 71, 72 for the via contact on the device or on the flip chip package F as shown by FIG. 2 (left scheme). FIG. 2 schematically represents the two sectional views of Semi-Insulating Buried Heterostructures (SIBH) of FIG. 1 in which pillars 71, 72 are generated for obtaining structures with metal contacts 8 at the same level, one of the structures being encapsulated in a resin R for overcoming mechanical weakness issues (see FIG. 2, right scheme 2). However, it generates a thermal resistivity. A bad heat evacuation penalizes strongly the performances of the chip.

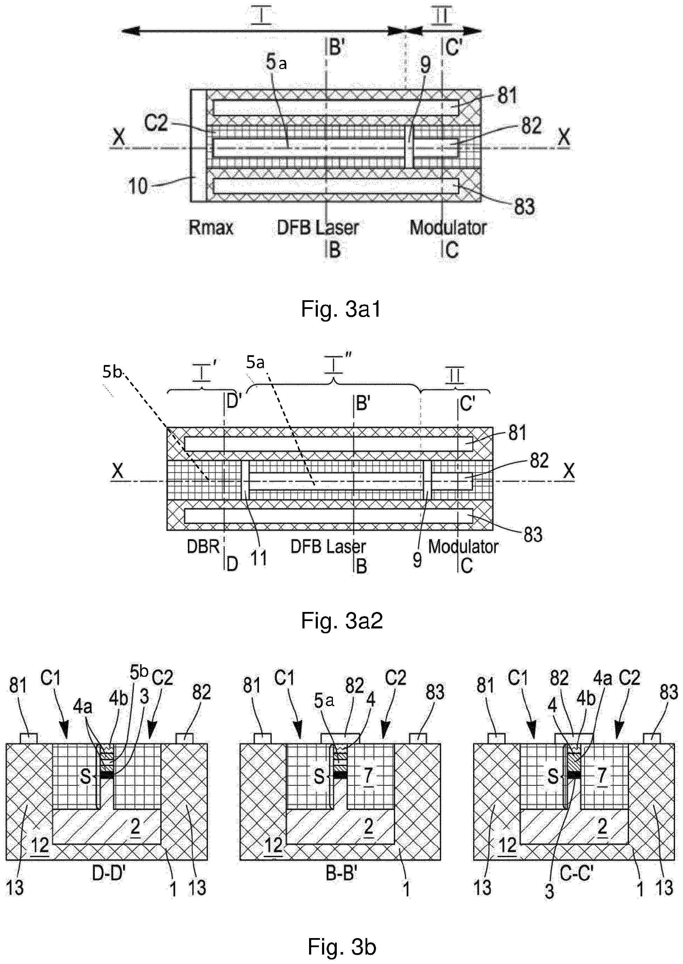

FIGs. 3a to 3c schematically represent two specific embodiments of an EML device D according to the present invention that overcomes the above-mentioned drawbacks.

FIG. 3a shows two respective top views (FIG. 3a1 and FIG. 3a2) of these two respective embodiments of the EML device D. FIG. 3a1. shows a first embodiment of the EML device comprising a combination of DFB laser and Rₘₐₓ mirror and FIG.3a2 shows a second embodiment of the EML device comprising a combination of DFB laser and a distributed Bragg Reflector DBR.

FIG. 3b (middle and right parts) show two sectional views of the SiBH heterostructures of these embodiments according to the B-B' and C-C' planes applying to both examples, and another sectional view (left part of Fig. 3b) according to plane D-D' applying only to the second embodiment of FIG.3a2 ;

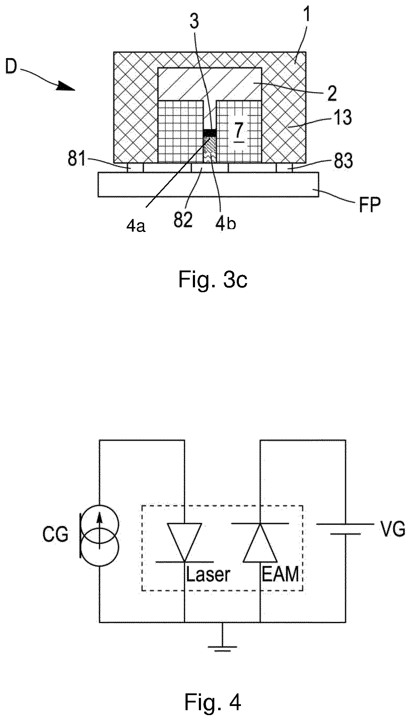

FIG. 3c shows an additional sectional view of both embodiments of the EML device according to the C-C' plane, with the EML device being flip-chipped on an electronic package.

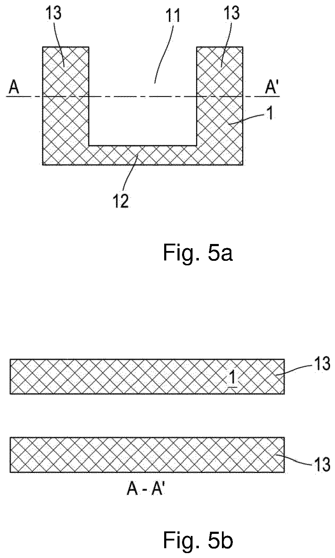

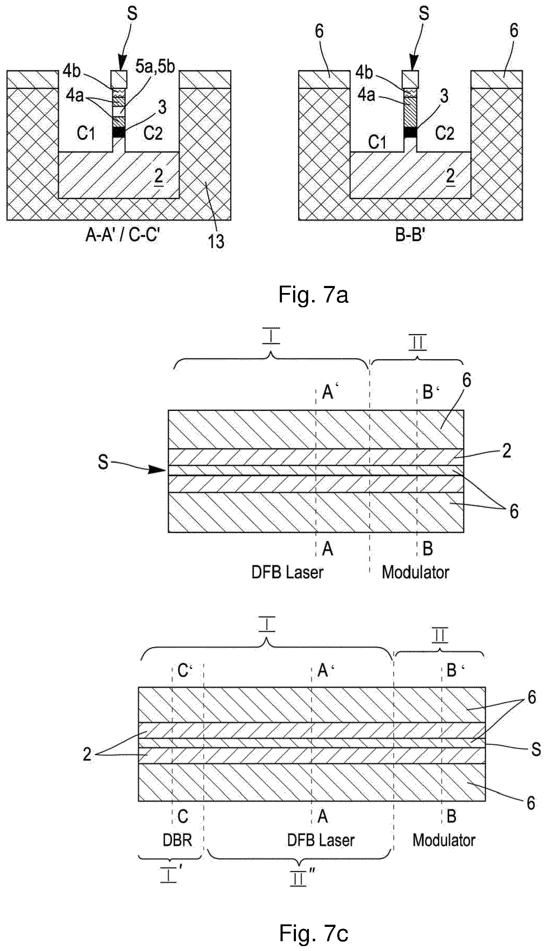

With respect to both examples of the EML device D, FIGs. 3a1, 3a2 and 3b show that it comprises:
- a substrate 1 made of III-V semiconductor material presenting a base 12 and side walls 13 and having a longitudinal axis XX (see FIG. 3a1,3a2), said substrate 1 being etched to form a groove 11 of U-shaped cross-section (see also FIG. 5a),
- a layer of n-doped III-V semi-conductor 2 disposed on the base 12 inside said groove 11 (see FIG. 3b and 7a);
- a central stripe portion S (see FIG 3b) comprising a buried waveguide 3 on which is grown a layer of p-doped III-V semi-conductor 4a and a p-doped III-V semiconductor contact layer 4b at least up to the level of the top of the side walls 13 (see FIG. 3b);
- two channels C1, C2 etched into the n-doped III-V semiconductor layer 2 along the longitudinal axis XX and being located along each side wall 13 on both sides of the central stripe portion S, the channels C1, C2 being each filled in by a regrown semi-insulating stack 7 up to the level of the top of the layer of p-doped III-V semi-conductor contact layer 4b (see FIG. 3b);
- within a zone of the central stripe portion (S) alongside the longitudinal axis XX constituting the first zone I, a Distributed Feedback Grating 5a etched inside the layer of p-doped III-V semi-conductor 4, the remaining zone constituting the second zone II (see FIG. 3a);
- metal stripes 81, 82, 83 disposed on the top of the side walls 13 and on the top of said stripe portion S (see FIG. 3b), these metal contacts being disposed on the upper side of the wafer at the same level;
- a first electrical separation 9 between the first I and second zones II consisting in a thin ribbon of implanted H+ located between the side walls 13 and perpendicular to longitudinal axis XX (see FIG. 3a1,3a2).

FIG. 3c shows that the metal contacts 81, 82, 83 are soldered on the flip-chip package FP. The EML device thus comprises a laser working in a continuous wave condition (corresponding to the optical waveguide 3 of the first zone I) and an EAM modulated in order to reach high frequencies without a limitation of optical power (corresponding to the optical waveguide 3 in the second zone, without DFB grating or DBR). The optical modulated signal is emitted by the front face of the device which is at the right of Figures 3a1 and 3a2. The optical functions integration is based on a single MQW layer (acronym for Multi Quantum Wells). The DFB grating 5a allows to define the laser wavelength.

With respect to the first example of the EML device (or first embodiment), figure 3a1 shows that EML device D may further comprise a dielectric mirror Rₘₐₓ 10 positioned at the end of the first zone I opposite to first electrical separation 9, that is to say on the rear face of the laser.

With respect to the second example of the EML device (or second embodiment), figure 3a2 and the left part of figure 3b show that EML device D comprises:
- a distributed Bragg Reflector (DBR) 5b etched within a first sub-zone I' located along the longitudinal axis XX in the first zone I and outside the part of the first zone I containing the Distributed Feedback Grating 5a which constitutes the second sub-zone (I"); and
- a second electrical separation 11 between the first I' and second sub-zone I" consisting of another thin ribbon of implanted H+ located between the side walls 13 and perpendicular to longitudinal axis XX.

FIG. 4 schematically represents the electrical scheme or equivalent circuit of the EML device: the laser function in zone I is powered by a current generator CG and the EAM function in zone II is reverse polarized by a voltage generator VG. Both current generator CG and voltage generator VG are not shown on figures 3a-c as they are lying outside of the EML laser and are connectable to the device D using the contact layers 81,82,83 .They can be made using state-of-the art techniques and be connected to the device D via cables, wires or electronic paths.

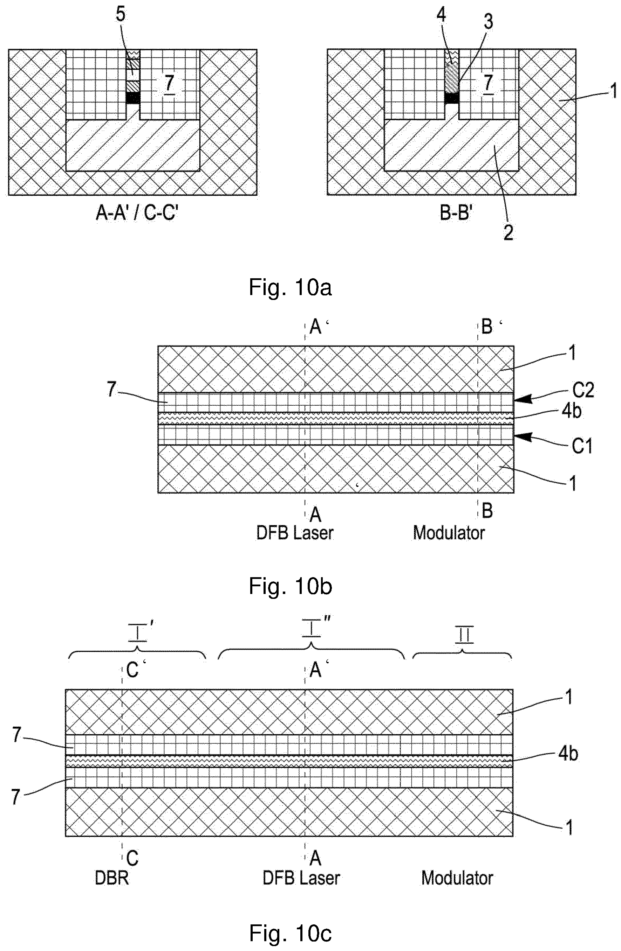

FIGs. 5 to 10 schematically represent the different steps of the process flow for fabricating an EML device D according to the embodiments represented in figure 3.

In particular, FIG. 5a schematically represents step A of providing a substrate 1 made of III-V semiconductor material

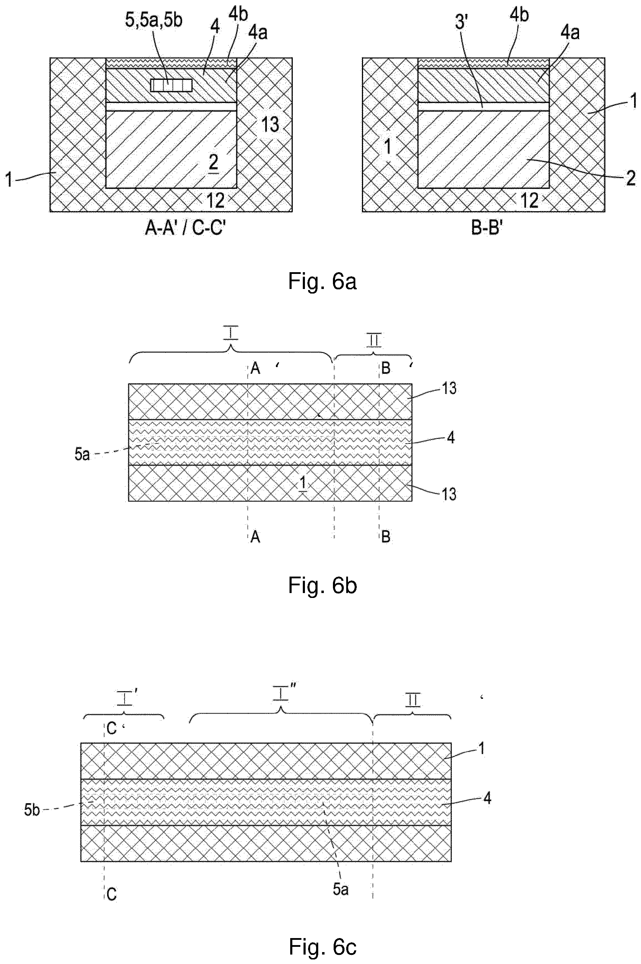

FIGs. 6a to 6c shows that the substrate 1 is then etched to form a groove 11 along a longitudinal axis of U-shaped cross-section and thus defining a base 12 and side walls 13 (step B) . Then a stack of layers comprising a layer of n-doped III-V semiconductor 2 on the base 1), an active material stack 3' on said layer of n-doped III-V semi-conductor 2, first p-doped III-V semiconductor 4a (such as InP),second p-doped III-V semi-conductors (such as InP and AlGaInP or GaInAsP) constituting the grating layers 5 are epitaxied (step C .

Then, within a zone of the EML device D alongside the axis XX constituting the first zone I, a Distributed Feedback Grating 5a is etched in the grating layers 5 (step D), the remaining zone constituting the second zone II (for both examples: see FIGs. 6a to 6c).

FIG. 6c shows that step D may further comprise the etching of a DBR 5b inside the grating layers 5 within a first sub-zone I' located along the axis XX in the first zone I and outside the part of the first zone I containing the Distributed Feedback Grating 5a which constitutes the second sub-zone I" (for the second example only).

Then during step E the Distributed Bragg Reflector 5b and the Distributed Feedback Grating 5a are buried simultaneously by the layer 4 of p-doped III-V semi-conductor.

FIG. 7 shows that step E is followed by a step G of depositing a dielectric mask 6 on the layer of p-doped III-V semi-conductor 4. This step is followed by a step H of etching, along the axis XX, two channels C1, C2 at least below the level of the active material stack 3', each channel C1, C2 being located along each side wall 13 of the substrate 1, so as to define a central stripe portion S comprising the etched material stack 3 constituting the optical waveguide 3 and the etched layer of p-doped III-V semiconductor 4.

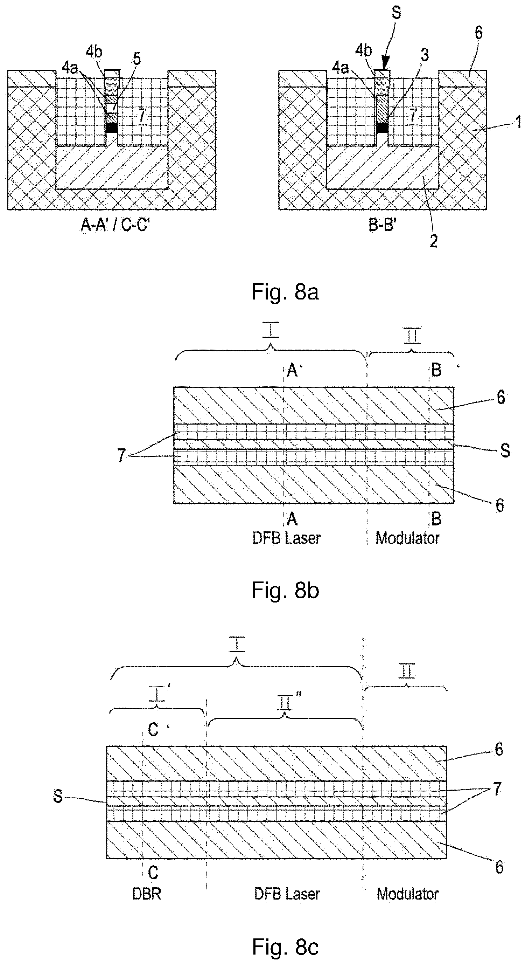

Then, FIGs. 8a to 8c show that a semi-insulating stack 7 is regrown at least up to the level of the top of the layer of the p-doped III-V semi-conductor contact layer 4b (step I).

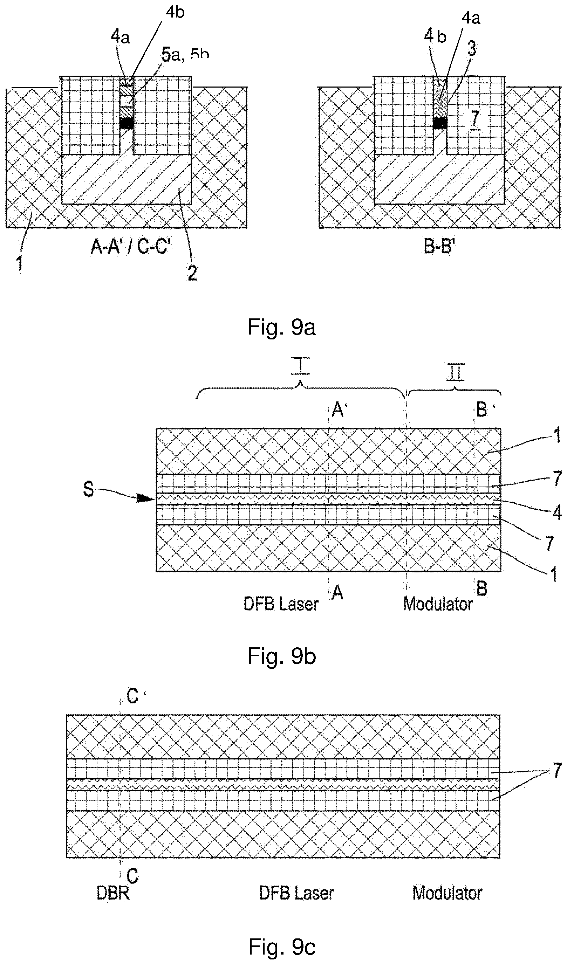

FIG. 9 shows that step I of regrowth is followed by the removing the remaining dielectric mask 6 (step J). If stack 7 is regrown over the n InP substrate, there may be an optional step J' of chemical and/or mechanical surface stripping of the stack 7, to flatten it to the level of the top of the side walls 13.

Then FIG. 3a1 to c shows, for both examples of the EML device D, that metal stripes 81, 82, 83 are formed (step K) along the axis XX (see notably FIG. 3a) and on the top of the side walls 13 and on the top of the central stripe portion (see notably FIGs. 3a1, 3a2 and 3b). Step K is followed (for both embodiments: see FIGs. 3b and 3c) by step L of forming a first electrical separation 9 between the first I and second zones II by implanting H+ ions within a thin ribbon of implanted H+ located between the side walls 13 and perpendicular to the axis XX.

According to a first example of the method of fabricating the EML device D (or first embodiment), the step L of forming the first electrical separation 9 may be followed by a step M of positioning a dielectric mirror Rₘₐₓ 10 at the end of the first zone I opposite to the first electrical separation 9, so as to obtain an EML device D according to the first example of the general embodiment.

According to a second example (or second embodiment)of the method of fabricating the EML device D, step L further comprises the forming of a second electrical separation 11 between the first I' and the second sub-zone I" by implanting H+ ions within another thin ribbon of implanted H+ located between the side walls 13 and perpendicular to the axis XX, provided that a DBR 5' has been previously etched into the p-doped III-V semiconductor layer 4 in step F (see above).

## Claims

1. Electro-absorption modulated laser device (D) comprising:
- a substrate (1) made of III-V semiconductor material presenting a base (12) and side walls (13) and having a longitudinal axis (XX), said substrate (1) being etched to form a groove (11) of U-shaped cross-section,
- a layer of n-doped III-V semi-conductor (2) disposed on the base (12) inside said groove (11);
- a central stripe portion (S) comprising a buried waveguide (3) on which is grown a layer of p-doped III-V semiconductor (4a) and a p-doped III-V semi-conductor contact layer (4b) at least up to the level of the top of the side walls (13);
- two channels (C1, C2) etched into the n-doped III-V semiconductor layer (2) along the longitudinal axis (XX) and being located along each side wall (13) on both sides of the central stripe portion (S), said channels (C1, C2) being each filled by a regrown semi-insulating stack (7) up to the level of the top of the p-doped III-V semiconductor contact layer (4b);
- within a zone of the central stripe portion (S) alongside the longitudinal axis (XX) constituting the first zone (I), a Distributed Feedback Grating (5a) etched inside the layer of p-doped III-V semi-conductor (4), the remaining zone constituting the second zone (II);
- metal stripes (81, 82, 83) disposed on the top of the side walls (13) and on the top of said the stripe portion (S);
- a first electrical separation (9) between the first (I) and second zones (II) consisting in a thin ribbon of implanted H+ located between the side walls (13) and perpendicular to longitudinal axis (XX).

2. Electro-absorption modulated laser device (D) according to claim 1, further comprising a dielectric mirror Rₘₐₓ (10) positioned at the end of the first zone (I) opposite to first electrical separation (9).

3. Electro-absorption modulated laser device (D) according to anyone of claims 1 and 2, further comprising:
- a distributed Bragg Reflector (DBR) (5b) etched inside the layer of p-doped III-V semi-conductor (4) within a first sub-zone (I') located along said longitudinal axis (XX) in the first zone (I) and outside the part of the first zone (I) containing the Distributed Feedback Grating (5a) which constitutes the second sub-zone (I"); and
- a second electrical separation (11) between the first (I') and second sub-zoned (I") consisting in another thin ribbon of implanted H+ located between the side walls (13) and perpendicular to longitudinal axis (XX).

4. Method of fabricating an electro-absorption modulated laser device (D) as defined in anyone of claims 1 to 3, said method comprising:
A. providing a substrate (1) made of III-V semiconductor material with a longitudinal axis (XX),
B. etching said substrate (1) to form a groove (11) of U-shaped cross-section and thus to define a base (12) and side walls (13) ;
C. performing an epitaxial growth of a stack of layers comprising a layer of n-doped III-V semi-conductor (2) on the base (12), an active material stack (3') on said layer of n-doped III-V semi-conductor (2), and p-doped III-V semi-conductors (such as InP and AlGaInP or GaInAsP) constituting the grating layers (5) ;
D. within a zone of electro-absorption modulated laser device (D) alongside said longitudinal axis (XX) constituting the first zone (I), etching a Distributed Feedback Grating (5a) inside the grating layers (5), the remaining zone constituting the second zone (II);
E. performing an epitaxial growth of a layer (4a) of p-doped III-V semi-conductor (4a) and a p-doped III-V semi-conductor contact layer (4b) to bury said Distributed Feedback Grating (5a) ;
F. depositing a dielectric mask (6) on the layer of p-doped III-V semi-conductor (4);
G. etching, along the longitudinal axis (XX), two channels (C1, C2) at least below the level of the active material stack (3'), each channel (C1, C2) being located along each side wall (13) of the substrate (1), so as to define a central stripe portion (S) comprising the etched material stack (3') constituting the optical waveguide (3) and the etched layer of p-doped III-V semi-conductor (4);
H. performing an epitaxial regrowth of a semi-insulating stack (7) up to the level of the top of the p-doped III-V semiconductor contact layer (4b);
I. removing the remaining dielectric mask (7);
J. depositing, along said longitudinal axis (XX), three metal stripes (81, 82, 83) on the top of the side walls (13) and on the top of said central stripe portion (S);
K. forming a first electrical separation (9) between the first (I) and second zones (II) by implanting H+ ions within a thin ribbon of implanted H+ located between the side walls (13) and perpendicular to longitudinal axis (XX).

5. Method of fabrication according to claim 4, further comprising after step K of forming the first electrical separation (9), a step L of positioning a dielectric mirror Rₘₐₓ (10) at the end of the first zone (I) opposite to the first electrical separation (9) .

6. Method of fabrication according to claim 4,
- wherein step D further comprises, the etching of a Distributed Bragg Reflector (5b) inside the grating layers (5) within a first sub-zone (I') located along said longitudinal axis (XX) in the first zone (I) and outside the part of the first zone (I) containing the Distributed Feedback Grating (5a) which constitutes the second sub-zone (I"), the etching of the Distributed Bragg Reflector (5b) and the etching of the Distributed Feedback Grating (5a) being realized simultaneously;
- wherein during step E) said Distributed Bragg Reflector (5b) and said Distributed Feedback Grating (5a) are buried simultaneously by the layer (4) of p-doped III-V semi-conductor;
- wherein step K is followed by a step M of forming of a second electrical separation (11) between the first (I') and second sub-zone (I") by implanting H+ ions within another thin ribbon of implanted H+ located between the side walls (13) and perpendicular to longitudinal axis (XX).

7. Method of fabrication according to anyone of claims 5 and 6, further comprising, between steps I and J, a step I' of chemical and/or mechanical surface stripping of the regrown semi-insulating stack (7), to flatten it to the level of the top of the side walls (13) .

## Patentansprüche

1. Elektroabsorptionsmodulierte Laservorrichtung (D), die Folgendes umfasst:
- ein Substrat (1), das aus einem III-V-Halbleitermaterial besteht, eine Basis (12) und Seitenwände (13) präsentiert und eine Längsachse (XX) aufweist, wobei das Substrat (1) geätzt wird, um eine Nut (11) eines U-förmigen Querschnitts zu bilden,
- eine Schicht eines n-dotierten III-V-Halbleiters (2), die auf der Basis (12) in der Nut (11) angeordnet ist;
- einen zentralen Streifenabschnitt (S), der einen versenkten Lichtwellenleiter (3) umfasst, auf dem eine Schicht eines p-dotierten III-V-Halbleiters (4a) und einer p-dotierten III-V-Halbleiterkontaktschicht (4b) mindestens bis zum Niveau der Oberkante der Seitenwände (13) aufgebaut ist;
- zwei Kanäle (C1, C2), die in die n-dotierte III-V-Halbleiterschicht (2) entlang der Längsachse (XX) geätzt sind und sich auf beiden Seiten des zentralen Streifenabschnitts (S) entlang jeder Seitenwand (13) befinden, wobei die Kanäle (C1, C2) jeweils bis zu einem Niveau der Oberkante der p-dotierten III-V-Halbleiterkontaktschicht (4b) mit einem neu aufgebauten halbisolierenden Stapel (7) gefüllt sind;
- ein verteiltes Rückkopplungsgitter (5a), das in einer Zone des zentralen Streifenabschnitts (S) entlang der Längsachse (XX), die die erste Zone (I) konstituiert, in die Schicht des p-dotierten III-V-Halbleiters (4) geätzt ist, wobei die verbleibende Zone die zweite Zone (II) konstituiert;
- Metallstreifen (81, 82, 83), die auf der Oberkante der Seitenwände (13) und auf der Oberkante des Streifenabschnitts (S) angeordnet sind;
- eine erste elektrische Trennung (9) zwischen der ersten (I) und der zweiten Zone (II), die aus einem dünnen Band von implantiertem H+ besteht und sich zwischen den Seitenwänden (13) und senkrecht zur Längsachse (XX) befindet.

2. Elektroabsorptionsmodulierte Laservorrichtung (D) nach Anspruch 1, die ferner einen dielektrischen Spiegel Rₘₐₓ (10) umfasst, der am Ende der ersten Zone (I) gegenüber der ersten elektrischen Trennung (9) positioniert ist.

3. Elektroabsorptionsmodulierte Laservorrichtung (D) nach einem der Ansprüche 1 und 2, die Folgendes umfasst:
- einen verteilten Bragg-Reflektor (DBR) (5b), der in die Schicht des p-dotierten III-V-Halbleiters (4) in einer ersten Unterzone (I`) geätzt ist, die sich entlang der Längsachse (XX) in der ersten Zone (I) und außerhalb des Teils der ersten Zone (I) befindet, die das verteilte Rückkopplungsgitter (5a) enthält, die die zweite Unterzone (I") konstituiert; und
- eine zweite elektrische Trennung (11) zwischen der ersten (I`) und der zweiten Unterzone (I"), die aus einem weiteren dünnen Band von implantiertem H+ besteht und sich zwischen den Seitenwänden (13) und senkrecht zur Längsachse (XX) befindet.

4. Verfahren zum Herstellen einer elektroabsorptionsmodulierten Laservorrichtung (D), wie in einem der Ansprüche 1 bis 3 definiert, wobei das Verfahren Folgendes umfasst:
A. Bereitstellen eines Substrats (1), das aus einem III-V-Halbleitermaterial mit einer Längsachse (XX) besteht,
B. Ätzen des Substrats (1), um eine Nut (11) eines U-förmigen Querschnitts zu bilden und somit eine Basis (12) und Seitenwände (13) zu definieren;
C. Durchführen eines epitaxialen Aufbaus eines Stapels von Schichten, die eine Schicht eines n-dotierten III-V-Halbleiters (2) auf der Basis (12), einen aktiven Materialstapel (3') auf der Schicht des n-dotierten III-V-Halbleiters (2) und p-dotierte III-V-Halbleiter (wie etwa InP und AlGaInP oder GaInAsP) umfassen, die die Gitterschichten (5) konstituieren;
D. Ätzen eines verteilten Rückkopplungsgitters (5a) in den Gitterschichten (5) in einer Zone einer elektroabsorptionsmodulierten Laservorrichtung (D) entlang der Längsachse (XX), die die erste Zone (I) konstituiert, wobei die verbleibende Zone die zweite Zone (II) konstituiert;
E. Durchführen eines epitaxialen Aufbaus einer Schicht (4a) eines p-dotierten III-V-Halbleiters (4a) und einer p-dotierten III-V-Halbleiterkontaktschicht (4b) um das verteilte Rückkopplungsgitter (5a) zu versenken;
F. Auftragen einer dielektrischen Maske (6) auf die Schicht des p-dotierten III-V-Halbleiters (4);
G. Ätzen von zwei Kanälen (C1, C2) entlang der Längsachse (XX) mindestens unter dem Niveau des aktiven Materialstapels (3'), wobei sich jeder Kanal (C1, C2) entlang jeder Seitenwand (13) des Substrats (1) befindet, um einen zentralen Streifenabschnitt (S) zu definieren, der den geätzten Materialstapel (3') umfasst, der den optischen Lichtwellenleiter (3) und die geätzte Schicht des p-dotierten III-V-Halbleiters (4) konstituiert;
H. Durchführen eines epitaxialen Neuaufbaus eines halbisolierenden Stapels (7) bis zum Niveau der Oberkante der p-dotierten III-V-Halbleiterkontaktschicht (4b);
I. Entfernen der verbleibenden dielektrischen Maske (7);
J. Auftragen von drei Metallstreifen (81, 82, 83) entlang der Längsachse (XX) auf die Oberkante der Seitenwände (13) und auf die Oberkante des zentralen Streifenabschnitts (S);
K. Bilden einer ersten elektrischen Trennung (9) zwischen der ersten (I) und der zweiten Zone (II) durch Implantieren von H+-Ionen in ein dünnes Band von implantiertem H+, die sich zwischen den Seitenwänden (13) und senkrecht zur Längsachse (XX) befindet.

5. Verfahren zum Herstellen nach Anspruch 4, das ferner nach Schritt K des Bildens der ersten elektrischen Trennung (9) ferner einen Schritt L des Positionierens eines dielektrischen Spiegels Rₘₐₓ (10) am Ende der ersten Zone (I) gegenüber der ersten elektrischen Trennung (9) umfasst.

6. Verfahren zum Herstellen nach Anspruch 4,
- wobei Schritt D ferner das Ätzen eines verteilten Bragg-Reflektors (5b) in den Gitterschichten (5) in einer ersten Unterzone (I`) umfasst, die sich entlang der Längsachse (XX) in der ersten Zone (I) und außerhalb des Teils der ersten Zone (I) befindet, die das verteilte Rückkopplungsgitter (5a) enthält, die die zweite Unterzone (I") konstituiert, wobei das Ätzen des verteilten Bragg-Reflektors (5b) und das Ätzen des verteilten Rückkopplungsgitters (5a) gleichzeitig realisiert werden;
- wobei beim Schritt E) der verteilte Bragg-Reflektor (5b) und das verteilte Rückkopplungsgitter (5a) durch die Schicht (4) des p-dotierten III-V-Halbleiters gleichzeitig versenkt werden;
- wobei auf Schritt K ein Schritt M folgt, um durch Implantieren von H+-Ionen in ein weiteres dünnes Band von implantiertem H+ zwischen der ersten (I') und der zweiten Unterzone (I") eine zweite elektrische Trennung (11) zu bilden, die sich zwischen den Seitenwänden (13) und senkrecht zur Längsachse (XX) befindet.

7. Verfahren zum Herstellen nach einem der Ansprüche 5 und 6, das zwischen den Schritten I und J ferner einen Schritt I' zur chemischen und/oder mechanischen Oberflächenabtragung des neu aufgebauten halbisolierenden Stapels (7) umfasst, um ihn auf das Niveau der Oberkante der Seitenwände (13) abzuflachen.

## Revendications

1. Dispositif laser modulé par électro-absorption (D) comprenant :
- un substrat (1) réalisé en un matériau semi-conducteur III-V présentant une base (12) et des parois latérales (13) et ayant un axe longitudinal (XX), ledit substrat (1) étant gravé pour former une rainure (11) de section transversale en forme de U,
- une couche d'un semi-conducteur III-V dopé n (2) disposée sur la base (12) à l'intérieur de ladite rainure (11) ;
- une portion de bande (S) centrale comprenant un guide d'ondes (3) enterré sur lequel on fait croître une couche de semi-conducteur III-V dopé p (4a) et une couche de contact de semi-conducteur III-V dopé p (4b) au moins jusqu'en haut des parois latérales (13) ;
- deux canaux (C1, C2) gravés dans la couche de semi-conducteur III-V dopé n (2) le long de l'axe longitudinal (XX) et situés le long de chaque paroi latérale (13) des deux côtés de la portion de bande (S) centrale, lesdits canaux (C1, C2) étant chacun remplis d'un empilement semi-isolant (7) mis à nouveau à croître jusqu'en haut de la couche de contact de semi-conducteur III-V dopé p (4b) ;
- dans une zone de la portion de bande (S) centrale à côté de l'axe longitudinal (XX) constituant la première zone (I), un réseau à rétroaction distribuée (5a) gravé à l'intérieur de la couche de semi-conducteur III-V dopé p (4), la zone restante constituant la deuxième zone (II) ;
- des bandes métalliques (81, 82, 83) disposées sur le haut des parois latérales (13) et sur le haut de ladite portion de bande (S) ;
- une première séparation électrique (9) entre la première zone (I) et la deuxième zone (II) consistant en un mince ruban de H+ implanté situé entre les parois latérales (13) et perpendiculaire à l'axe longitudinal (XX).

2. Dispositif laser modulé par électro-absorption (D) selon la revendication 1, comprenant en outre un miroir diélectrique Rₘₐₓ (10) positionné à l'extrémité de la première zone (I) opposée à une première séparation électrique (9).

3. Dispositif laser modulé par électro-absorption (D) selon l'une des revendications 1 et 2, comprenant en outre :
- un réflecteur de Bragg distribué (DBR) (5b) gravé à l'intérieur de la couche de semi-conducteur III-V dopé p (4) dans une première sous-zone (I') située le long dudit axe longitudinal (XX) de la première zone (I) et à l'extérieur de la partie de la première zone (I) contenant le réseau à rétroaction distribuée (5a) qui constitue la deuxième sous-zone (I") ; et
- une deuxième séparation électrique (11) entre la première sous-zone (I') et la deuxième sous-zone (I") consistant en un autre mince ruban de H+ implanté situé entre les parois latérales (13) et perpendiculaire à l'axe longitudinal (XX).

4. Procédé de fabrication d'un dispositif laser modulé par électro-absorption (D) selon l'une des revendications 1 à 3, ledit procédé comprenant les étapes suivantes :
A. fournir un substrat (1) réalisé en un matériau semi-conducteur III-V ayant un axe longitudinal (XX),
B. graver ledit substrat (1) pour former une rainure (11) de section transversale en forme de U et pour définir ainsi une base (12) et des parois latérales (13) ;
C. réaliser une croissance épitaxiale d'un empilement de couches comprenant une couche d'un semi-conducteur III-V dopé n (2) sur la base (12), un empilement de matériau actif (3') sur ladite couche d'un semi-conducteur III-V dopé n (2), et des semi-conducteurs III-V dopés p (tels que InP et AlGaInP ou GaInAsP) constituant les couches de réseau (5) ;
D. dans une zone d'un dispositif laser modulé par électro-absorption (D) à côté dudit axe longitudinal (XX) constituant la première zone (I), graver un réseau à rétroaction distribuée (5a) à l'intérieur des couches de réseau (5), la zone restante constituant la deuxième zone (II) ;
E. réaliser une croissance épitaxiale d'une couche (4a) d'un semi-conducteur III-V dopé p (4a) et d'une couche de contact de semi-conducteur III-V dopé p (4b) pour enterrer ledit réseau à rétroaction distribuée (5a) ;
F. déposer un masque diélectrique (6) sur la couche de semi-conducteur III-V dopé p (4) ;
G. graver, le long de l'axe longitudinal (XX), deux canaux (C1, C2) au moins au-dessous du niveau de l'empilement de matériau actif (3'), chaque canal (C1, C2) étant situé le long de chaque paroi latérale (13) du substrat (1), de manière à définir une portion de bande (S) centrale comprenant l'empilement de matériau (3') gravé constituant le guide d'ondes (3) optique et la couche de semi-conducteur III-V dopé p (4) gravée ;
H. réaliser une nouvelle croissance épitaxiale d'un empilement semi-isolant (7) jusqu'en haut de la couche de contact de semi-conducteur III-V dopé p (4b) ;
I. retirer le masque diélectrique (7) restant ;
J. déposer, le long dudit axe longitudinal (XX), trois bandes métalliques (81, 82, 83) sur le haut des parois latérales (13) et sur le haut de ladite portion de bande (S) centrale ;
K. former une première séparation électrique (9) entre la première zone (I) et la deuxième zone (II) en implantant des ions H+ dans un mince ruban de H+ implanté situé entre les parois latérales (13) et perpendiculaire à l'axe longitudinal (XX).

5. Procédé de fabrication selon la revendication 4, comprenant en outre, après l'étape K de formation de la première séparation électrique (9), une étape L de positionnement d'un miroir diélectrique Rₘₐₓ (10) à l'extrémité de la première zone (I) opposée à la première séparation électrique (9).

6. Procédé de fabrication selon la revendication 4,
- dans lequel l'étape D comprend en outre la gravure d'un réflecteur de Bragg distribué (5b) à l'intérieur des couches de réseau (5) dans une première sous-zone (I') située le long dudit axe longitudinal (XX) de la première zone (I) et à l'extérieur de la partie de la première zone (I) contenant le réseau à rétroaction distribuée (5a) qui constitue la deuxième sous-zone (I"), la gravure du réflecteur de Bragg distribué (5b) et la gravure du réseau à rétroaction distribuée (5a) étant réalisées simultanément ;
- dans lequel au cours de l'étape E), ledit réflecteur de Bragg distribué (5b) et ledit réseau à rétroaction distribuée (5a) sont enterrés simultanément par la couche (4) d'un semi-conducteur III-V dopé p ;
- dans lequel l'étape K est suivie d'une étape M de formation d'une deuxième séparation électrique (11) entre la première sous-zone (I') et la deuxième sous-zone (I") en implantant des ions H+ dans un autre mince ruban de H+ implanté situé entre les parois latérales (13) et perpendiculaire à l'axe longitudinal (XX).

7. Procédé de fabrication selon l'une des revendications 5 et 6, comprenant en outre, entre les étapes I et J, une étape I' de décapage chimique et/ou mécanique de la surface de l'empilement semi-isolant (7) mis à nouveau à croître, pour l'aplanir au niveau du haut des parois latérales (13).
